# EUROPÄISCHE PATENTANMELDUNG

(11) **EP 3 736 355 A1**
(43) Veröffentlichungstag der Anmeldung: **11.11.2020**
(21) Anmeldenummer: 19172672.8
(22) Anmeldetag: 06.05.2019
(51) Int. Cl.: C23C 14/06, C23C 14/58, B01D 5/00

(54) **VERFAHREN UND VORRICHTUNG ZUR HERSTELLUNG EINES CHALKOGENHALTIGEN VERBINDUNGSHALBLEITERS**

(71) Anmelder: (CNBM) Bengbu Design & Research Institute for Glass Industry Co., Ltd., 233010 Bengbu (CN)
(72) Erfinder: Die Erfindernennung liegt noch nicht vor
(74) Vertreter: Gebauer, Dieter Edmund

(57) **Zusammenfassung**

Die Erfindung betrifft ein Verfahren zum Herstellen eines chalkogenhaltigen Verbindungshalbleiters, welches umfasst:
- Bereitstellen mindestens eines mit einem Vorläufer (4) für den chalkogenhaltigen Verbindungshalbleiter beschichteten Substrats (5) in einem Prozessraum (3),
- Wärmebehandeln des mindestens einen beschichteten Substrats (5) im Prozessraum (3), wobei während der Wärmebehandlung eine Gasatmosphäre, die mindestens eine gasförmige Chalkogenverbindung aufweist, im Prozessraum (3) bereitgestellt wird,
- Entfernen der nach dem Wärmebehandeln des mindestens einen beschichteten Substrats (5) vorliegenden Gasatmosphäre als Abgas aus dem Prozessraum (3),
- Kühlen des Abgases, wobei mindestens eine gasförmige Chalkogenverbindung, die nach dem Wärmebehandeln des beschichteten Substrats (5) im Abgas vorhanden ist, durch Überführen in eine flüssige oder feste Form vom Abgas separiert wird. Die Erfindung erstreckt sich weiterhin auf eine zur Durchführung des Verfahrens geeignete ausgebildete Vorrichtung.

## Beschreibung

Die vorliegende Erfindung liegt auf dem technischen Gebiet der Herstellung von Dünnschichtsolarzellen und betrifft ein Verfahren und eine Vorrichtung zur Herstellung eines chalkogenhaltigen Verbindungshalbleiters, der in Dünnschichtsolarzellen als Absorber zur fotoelektrischen Konversion dient.

In Dünnschichtsolarzellen wird das halbleitende Material des zur fotoelektrischen Konversion eingesetzten Absorbers so gewählt, dass das einfallende Sonnenlicht mit einem guten Wirkungsgrad in elektrischen Strom umgewandelt werden kann. Aufgrund der physikalischen Eigenschaften und der technologischen Handhabbarkeit sind Absorber aus amorphem, mikromorphem oder polykristallinem Silizium, Cadmium-Tellurid (CdTe), Gallium-Arsenid (GaAs), Kupfer-Indium/Gallium-Diselenid/Disulfid/Disulfoselenid (Cu(In,Ga)(S,Se)₂), Kupfer-Zink-Zinn-Sulfo-Selenid (CZTS aus der Gruppe der Kesterite) und organischen Halbleitern in besonderer Weise geeignet. Der pentenäre Halbleiter Cu(In,Ga)(S,Se)₂, der zur Gruppe der Chalkopyrit-Verbindungshalbleiter gehört, hat in der industriellen Serienfertigung von Dünnschichtsolarzellen eine besondere Bedeutung erlangt.

Die Herstellung von chalkogenhaltigen Verbindungshalbleitern, insbesondere Absorbern aus Cu(In,Ga)(S,Se)₂, erfolgt zweckmäßig durch einen Zweistufenprozess. Solche zweistufigen Verfahren sind beispielsweise aus J. Palm et al., "CIS module pilot processing applying concurrent rapid selenization and sulfurization of large area thin film Vorläufers", Thin Solid Films 431-432, S. 414-522 (2003) bekannt.

Hierbei wird in einer ersten Stufe ein Vorläufer des chalkogenhaltigen Verbindungshalbleiters ("Precursor") auf ein Substrat aufgebracht, gefolgt von einer zweiten Stufe, in der das mit dem Vorläufer beschichtete Substrat in einer mindestens eine Chalkogenverbindung enthaltenden Gasatmosphäre wärmebehandelt wird. Durch die Wärmebehandlung, typischer Weise eine so genannte RTP-Wärmebehandlung (RTP = Rapid Thermal Processing) oder in einem langsameren Stapelofen-Prozess, erfolgt die Kristallbildung und Phasenumwandlung des Vorläufers zur Halbleiterschicht.

Für die Herstellung eines chalkogenhaltigen Verbindungshalbleiters aus Cu(In,Ga)(S,Se)₂ wird als Vorläufer beispielsweise ein Schichtenstapel, enthaltend die Metalle Kupfer, Indium und Gallium, vorzugsweise durch Sputtern, auf ein gläsernes Substrat abgeschieden. Typischer Weise, jedoch nicht zwingend, wird als weiterer Bestandteil des Vorläufers mindestens ein Chalkogen in elementarer Form (Selen und/oder Schwefel) durch thermisches Verdampfen auf das Substrat abgeschieden. Bei diesen Abscheideprozessen liegt die Temperatur des Substrats in der Regel unterhalb von 100°C, so dass die Elemente im Wesentlichen als Metalllegierung und elementares Chalkogen unreagiert erhalten bleiben. Anschließend wird der Vorläufer durch Erwärmen in einer mindestens eine Chalkogenverbindung enthaltenden Atmosphäre zum Cu(In,Ga)(S,Se)₂-Verbindungshalbleiter thermisch umgesetzt. Beispielsweise enthält der Vorläufer als Chalkogen nur elementares Selen und die thermische Umsetzung des Vorläufers erfolgt in einer Atmosphäre, die als Chalkogen nur eine Schwefelverbindung enthält. Durch die Wärmebehandlung des Vorläufers in der chalkogenhaltigen Atmosphäre erfolgt die Kristallbildung und Phasenumwandlung des Vorläufers zur Halbleiterschicht.

In entsprechender Weise kann durch ein zweistufiges Verfahren ein chalkogenhaltiger Kesterit-Verbindungshalbleiter hergestellt werden, wobei als Vorläufer ein Schichtenstapel auf das Substrat aufgebracht wird, der Kupfer, Zink, Zinn und optional mindestens ein elementares Chalkogen enthält. Anschließend wird der Vorläufer durch Erwärmen in einer Gasatmosphäre, welche mindestens eine Chalkogenverbindung enthält, zum Verbindungshalbleiter umgesetzt.

Typischer Weise wird in solchen zweistufigen Prozessen bei der thermischen Umsetzung des Vorläufers zum chalkogenhaltigen Verbindungshalbleiter mindestens eine Chalkogenverbindung in der Gasatmosphäre in Form einer Wasserstoffverbindung, beispielsweise Schwefelwasserstoff (Dihydrogensulfid, H₂S) oder Selenwasserstoff (Dihydrogenselenid, H₂Se), zugeführt.

Die Wärmebehandlung des mit einem Vorläufer beschichteten Substrats erfolgt entweder in In-Line-Anlagen oder in Stapelöfen. In In-Line Anlagen wird das beschichtete Substrat nacheinander verschiedenen Prozesskammern zugeführt, die entlang einer Prozesstraße angeordnet sind. In einem typischen Aufbau umfasst eine solche In-Line-Anlage eine Ladestation, mindestens eine Heizkammer, in der die beschichteten Substrate mit Aufheizgeschwindigkeiten von mehreren °C/s schnell erwärmt werden, sowie mindestens eine Kühlkammer, in der die beschichteten Substrate abgekühlt und aus der Anlage ausgeschleust werden. In einem Stapelofen werden viele beschichtete Substrate gleichzeitig in einem Ofen langsam aufgeheizt, wärmebehandelt und langsam wieder abgekühlt.

Generell ist die Herstellung eines chalkogenhaltigen Verbindungshalbleiters ein kostenintensiver und technisch anspruchsvoller Prozess, der hohe Temperaturen, einen genauen Temperaturverlauf und eine definierte Zusammensetzung der Gasatmosphäre erfordert, wenn hohe Wirkungsgrade mit ausreichend guter Reproduzierbarkeit erreicht werden sollen. So müssen beispielsweise bei der Fertigung hochwertiger Cu(In,Ga)(S,Se)₂-Verbindungshalbleiter der Dampfdruck und die Stoffmenge der mindestens einen Chalkogenverbindung in der Gasatmosphäre genau kontrolliert werden. Insbesondere ist eine ausreichende und definierte Chalkogenmenge nötig, um eine vollständige Sulfurisierung und/oder Selenisierung des Vorläufers zu gewährleisten. Deutlicher Chalkogen-Verlust würde zu einer unvollständigen Umwandlung des Vorläufers zum Verbindungshalbleiter führen. Selbst ein schwacher Chalkogen-Verlust kann noch zu Rekombination, d.h. Wirkungsgradverlust, und verstärkten Transienten (insbesondere Damp-Heat-Verluste) im fertigen Dünnschichtsolarmodul führen. Zweckmäßig bei der Wärmebehandlung ist die Verwendung von transportierbaren Prozessboxen oder in der Prozesskammer stationär angeordneten Prozesshauben, durch die der zur Verfügung stehende Prozessraum gegenüber dem Kammerhohlraum reduziert werden kann. Dies erleichtert die Einhaltung der gewünschten Prozessbedingungen.

Die bei der Wärmebehandlung zugeführten chalkogenhaltigen Gase, insbesondere Schwefelwasserstoff und Selenwasserstoff, sind äußerst korrosive Stoffe, die Metalle bei den bei der Wärmebehandlung erforderlichen hohen Temperaturen stark angreifen. Zudem sind diese Gase hochgiftig, brennbar und leicht entzündlich. In Kontakt mit Schleimhäuten führen sie zu lang anhaltenden Reizungen. Dies bedingt, dass das bei der Wärmebehandlung des Vorläufers im Prozessraum anfallende Abgas gereinigt werden muss, d.h. die darin enthaltenen Chalkogenverbindungen müssen weitestgehend entfernt werden, bevor es an die äußere Umgebung abgegeben werden kann. Dies ist in gleicher Weise sowohl für RTP-Prozesse als auch für Stapelofenprozesse notwendig. Insbesondere ist diese Reinigung immer erforderlich, wenn als Chalkogenquelle Chalkogenwasserstoffe eingesetzt werden.

Derzeit gängig ist die Verwendung eines Gaswäschers (Nassabscheider) zur Reinigung des bei der Wärmebehandlung des Vorläufers anfallenden Abgases. Hierzu wird das Abgas in eine Waschsäule geleitet und mit einer Flüssigkeit in Kontakt gebracht, welche die chalkogenhaltigen Bestandteile des Abgases absorbiert. Beispielsweise wird eine eisenhaltige, basische Lösung zur Absorption von Schwefelwasserstoff oder Selenwasserstoff eingesetzt. Diese Vorgehensweise ist effizient und verlässlich. Die verbleibende Konzentration von Schwefelwasserstoff oder Selenwasserstoff im gereinigten Abgas kann hierdurch auf unter 50 ppm gebracht werden. Jedoch muss das entstehende feste Reaktionsprodukt durch Druckfiltration von der Waschlösung separiert und anschließend als Sondermüll entsorgt werden. Um dies zu vermeiden, kann die Waschlösung einer nachgeschalteten Behandlung durch aerobe Mikroorganismen unterzogen werden, wodurch die schwefel- bzw. selenhaltigen Substanzen zu Sulfaten oxidiert werden. Die Waschlösung kann dann problemlos als Dünger eingesetzt werden. Eine alternative Waschlösung ist beispielsweise verdünnte Natronlauge, die mit Wasserstoffperoxid versetzt ist. Durch Wasserstoffperoxid werden Schwefelwasserstoff oder Selenwasserstoff zu Schwefelsäure bzw. Selensäure umgesetzt. Die Natronlauge neutralisiert die hierbei entstehenden Säuren. Bekannt ist auch die Verwendung fester Absorbermaterialien in einem Trockenabscheider.

Generell werden durch die Reinigung des Abgases, das bei der Wärmebehandlung des Vorläufers für einen chalkogenhaltigen Verbindungshalbleiter anfällt, hohe Kosten verursacht, welche die Gesamtkosten für die Herstellung von Dünnschichtsolarzellen deutlich erhöhen. Erschwerend kommt hinzu, dass das im Abgas verbliebenene Chalkogen durch die Reinigung verloren geht und nicht mehr weiter verwendet werden kann. Dies ist nachteilig, zumal die Nutzrate der in der Gasatmosphäre im Prozessraum bereitgestellten mindestens einen Chalkogenverbindung ohnehin relativ niedrig ist (z.B. 10%) und stets ein ausreichend hoher Gehalt an Chalkogen durch Einleiten eines Prozessgases in den Prozessraum sicherzustellen ist.

Die vorliegende Erfindung zielt auf eine Verbesserung eines solchen zweistufigen Prozesses für die Herstellung eines chalkogenhaltigen Verbindungshalbleiters ab, wobei eine kostengünstige, einfache und ökologisch vertretbare Herstellung des Verbindungshalbleiters in zuverlässiger und sicherer Weise in der industriellen Serienfertigung von Dünnschichtsolarmodulen ermöglicht sein soll.

Diese und weitere Aufgaben werden nach dem Vorschlag der Erfindung durch ein Verfahren und eine Vorrichtung zum Herstellen eines chalkogenhaltigen Verbindungshalbleites mit den Merkmalen der nebengeordneten Ansprüche gelöst. Bevorzugte Ausführungen der Erfindung gehen aus den Unteransprüchen hervor.

Erfindungsgemäß ist ein Verfahren zum Herstellen eines chalkogenhaltigen Verbindungshalbleiters gezeigt. Der Verbindungshalbleiter dient als Absorber in Dünnschichtsolarzellen zur fotoelektrischen Konversion von Sonnenlicht in elektrischen Strom.

Das erfindungsgemäße Verfahren ist Teil der Herstellung der Dünnschichtsolarzellen eines Dünnschichtsolarmoduls. Vorzugsweise handelt es sich um ein Dünnschichtsolarmodul mit Verbundscheibenstruktur, welches über eine Deckscheibe und eine Rückscheibe (z.B. Glasplatten) verfügt, die durch eine thermoplastische oder vernetzende Polymer-Zwischenschicht (z.B. PVB oder EVA) fest miteinander verbunden sind. Die Erfindung bezieht sich insbesondere auf ein Dünnschichtsolarmodul in Substratkonfiguration, bei der der Schichtenaufbau zur Herstellung der Dünnschichtsolarzellen auf einer der Lichteintrittsseite zugewandten Oberfläche eines rückseitigen Substrats aufgebracht ist, oder in Superstratkonfiguration, bei welcher der Schichtenaufbau auf einer von der Lichteintrittsseite abgewandten Oberfläche einer transparenten Deckscheibe aufgebracht ist. Der Schichtenaufbau für Dünnschichtsolarzellen umfasst in an sich bekannter Weise eine Rückelektrodenschicht, eine Frontelektrodenschicht, und eine zwischen Rück- und Frontelektrodenschicht angeordnete, fotovoltaisch aktive Absorberschicht.

In Einklang mit der üblichen Verwendung bezieht sich der Begriff "Dünnschichtsolarzelle" auf einen Schichtenaufbau zur Herstellung der Dünnschichtsolarzellen mit einer sehr geringen Dicke von beispielsweise einigen Mikrometern, was generell ein Substrat für eine ausreichende mechanische Festigkeit erfordert. Das Substrat besteht beispielsweise aus Glas, Kunststoff, Metall oder einer Metallegierung und kann in Abhängigkeit von der jeweiligen Schichtdicke und den spezifischen Materialeigenschaften als starre Platte oder biegsame Folie ausgestaltet sein. Bevorzugt besteht das Substrat aus Glas, insbesondere Kalk-Natron-Glas.

Der Vorläufer dient zur Herstellung eines chalkogenhaltigen Verbindungshalbleiters, wobei der Vorläufer in einer mindestens eine Chalkogenverbindung enthaltenden Gasatmosphäre zum Verbindungshalbleiter thermisch umgesetzt (reagiert) wird. Die thermische Umsetzung des Vorläufers erfolgt durch Erwärmen des mit dem Vorläufer beschichteten Substrats, typischer Weise durch einen RTP-Prozess oder in einem Stapelofenprozess. Im Sinne vorliegender Erfindung bezeichnet der Begriff "beschichtetes Substrat" ein mit einem Vorläufer für einen chalkogenhaltigen Verbindungshalbleiter beschichtetes Substrat.

Der Vorläufer enthält Materialien (Metalle und optional mindestens eine Chalkogen), die in einer mindestens eine Chalkogenverbindung enthaltenden Gasatmosphäre zum Verbindungshalbleiter umgesetzt werden. Der Vorläufer ist typischer Weise, jedoch nicht zwingend, in Form eines Schichtenstapels ausgebildet. Möglich ist auch, dass der Vorläufer aus einer verschiedene Materialien enthaltenden Einzelschicht besteht. Als Chalkogene werden die Elemente der 6. Hauptgruppe des Periodensystems bezeichnet. Das Verbindungshalbleiter sowie optional auch dessen Vorläufer enthält mindestens ein Chalkogen, vorzugsweise Schwefel und/oder Selen.

Bevorzugt handelt es sich bei dem Absorber um einen chalkogenhaltigen Chalkopyrit-Verbindungshalbleiter, vorteilhaft um einen ternären I-III-VI-Verbindungshalbleiter aus der Gruppe Kupfer-Indium/Gallium-Disulfid/Diselenid, abgekürzt durch die Formel Cu(In,Ga)(S,Se)₂. In vorstehender Formel können Indium und Gallium jeweils allein oder in Kombination vorliegen. Entsprechendes gilt für die Chalkogene Schwefel und Selen, die jeweils allein oder in Kombination vorliegen können. Als Material für den Absorber eignet sich in besonderer Weise CISe (Kupfer-Indium-Diselenid), CIS (Kupfer-Indium-Disulfid), CIGSe (Kupfer-Indium-Gallium-Diselenid) CIGS (Kupfer-Indium-Gallium-Disulfid) oder CIGSSe (Kupfer-Indium-Gallium-Disulfoselenid).

Gleichermaßen bevorzugt kann es sich bei dem Absorber um einen chalkogenhaltigen Kesterit-Verbindungshalbleiter handeln, vorzugsweise Kupfer-Zink-Zinn-Sulfoselenid (CZTS). Der chalkogenhaltige Kesterit-Verbindungshalbleiter enthält mindestens ein Chalkogen, vorzugsweise Schwefel und/oder Selen.

Der chalkogenhaltige Verbindungshalbleiter wird in einem zweistufigen Prozess hergestellt. Beispielsweise wird zur Herstellung einer Cu(In,Ga)(S,Se)₂-Absorberschicht auf einem Substrat, insbesondere nach Abscheiden einer Rückelektrodenschicht, zunächst ein Vorläufer auf ein Substrat aufgebracht, der die Elemente Kupfer, Indium und Gallium enthält, vorzugsweise durch Sputtern. Des Weiteren wird optional ein Chalkogen in elementarer Form aufgebracht, vorzugsweise Selen und/oder Schwefel, vorzugsweise durch thermisches Verdampfen. Bei diesen Abscheideprozessen liegt die Temperatur des Substrats typischer Weise unterhalb von 100°C, so dass die Elemente im Wesentlichen als Metalllegierung und elementares Chalkogen (Selen und/oder Schwefel) unreagiert erhalten bleiben. Anschließend wird der Vorläufer durch Erwärmen des beschichteten Substrats in einer mindestens eine Chalkogenverbindung enthaltenden Gasatmosphäre zum Cu(In,Ga)(S,Se)₂-Verbindungshalbleiter reagiert (thermisch umgesetzt). In der Gasatmosphäre ist die mindestens eine Chalkogenverbindung typischer Weise in Form einer Wasserstoffverbindung, vorzugsweise Schwefelwasserstoff (Dihydrogensulfid, H₂S) und/oder Selenwasserstoff (Dihydrogenselenid, H₂Se), enthalten.

Beispielsweise enthält der Vorläufer als Chalkogen nur elementares Selen und die thermische Umsetzung des Vorläufers erfolgt in einer Atmosphäre, die als Chalkogen nur eine Schwefelverbindung enthält. Der Vorläufer kann aber auch beispielsweise nur die Metalle Kupfer, Indium und Gallium enthalten und die thermische Umsetzung erfolgt in Chalkogenwasserstoffen, zum Beispiel erst in H₂Se und dann in H₂S (oder umgekehrt) oder in H₂Se/H₂S-Gasgemischen.

In entsprechender Weise kann in einem zweistufigen Verfahren ein chalkogenhaltiger Kesterit-Verbindungshalbleiter hergestellt werden, wobei zunächst ein Vorläufer auf die Rückelektrodenschicht aufgebracht wird, der Kupfer, Zink, Zinn und optional mindestens ein elementares Chalkogen (vorzugsweise Schwefel und/oder Selen, besonders bevorzugt nur Selen) enthält. Anschließend wird der Vorläufer durch Erwärmen des beschichteten Substrats in einer Gasatmosphäre, welche mindestens eine Chalkogenverbindung (vorzugsweise Schwefelwasserstoff (Dihydrogensulfid, H₂S) und/oder Selenwasserstoff (Dihydrogenselenid, H₂Se) enthält, zum Verbindungshalbleiter umgesetzt.

Erfindungsgemäß wird mindestens ein mit einem Vorläufer für die Herstellung eines chalkogenhaltigen Verbindungshalbleiters beschichtetes Substrat in einem Prozessraum bereitgestellt. Der Prozessraum ist von einer gasdichten oder (mindestens für den Zeitraum der Wärmebehandlung des Vorläufers) zumindest annähernd gasdichten Umhausung begrenzt, in die mindestens ein Prozessgas eingeleitet werden kann. Der Prozessraum ist beispielsweise der Kammerhohlraum einer Prozesskammer (Heizkammer). Alternativ ist es auch möglich, dass der Prozessraum in Bezug auf den Kammerhohlraum reduziert ist, wobei das beschichtete Substrat in einer transportablen Prozessbox aufgenommen ist, oder durch eine in der Prozesskammer stationär angeordnete Prozesshaube abgedeckt wird.

Anschließend wird das mindestens eine beschichtete Substrat wärmebehandelt (erwärmt). Durch die Wärmebehandlung erfolgt eine Umsetzung des Vorläufers zum Verbindungshalbleiter, wobei während der Wärmebehandlung eine Gasatmosphäre im Prozessraum bereitgestellt wird, die mindestens eine gasförmige Chalkogenverbindung aufweist. Der Begriff "Gasatmosphäre" bezeichnet die gasförmige Umgebung des Vorläufers, insbesondere während der Wärmebehandlung des Vorläufers im Prozessraum. Der Vorläufer ist der Gasatmosphäre im Prozessraum ausgesetzt. Die Gasatmosphäre im Prozessraum wird durch Einleiten eines Prozessgases vor und/oder während der Wärmebehandlung des beschichteten Substrats in den Prozessraum in gewünschter Weise eingestellt. Die Zufuhr des Prozessgases kann kontinuierlich oder diskontinuierlich erfolgen. Das Prozessgas enthält neben mindestens einer gasförmigen Chalkogenverbindung (vorzugsweise Schwefelwasserstoff (Dihydrogensulfid, H₂S) und/oder Selenwasserstoff (Dihydrogenselenid, H₂Se) typischer Weise ein zur Verdünnung der Konzentration der gasförmigen Chalkogenverbindung dienendes weiteres Gas, vorzugsweise Stickstoff (N₂).

Für eine Erwärmung des beschichteten Substrats im Prozessraum ist mindestens eine Energiequelle außerhalb und/oder innerhalb des Prozessraums angeordnet, wobei die Energiequelle vorzugsweise mindestens einen Heizstrahler zur Erzeugung einer Heizstrahlung umfasst und beispielsweise in Form eines Strahlerfelds mit einer ein- oder zweidimensionalen Anordnung von Heizstrahlern ausgebildet ist. Das beschichtete Substrat kann durch auftreffende Heizstrahlung direkt erwärmt werden und/oder durch von der Heizstrahlung erwärmte Flächen, beispielsweise Flächen einer Prozessbox, indirekt erwärmt werden (Wärmeleitung, Wärmestrahlung). Typischer Weise erfolgt eine Aufheizung des Vorläufers mit hohen Heizraten von einigen °C pro Sekunde.

Alternativ wird der Vorläufer in einem Stapelofen wärmebehandelt. Dafür werden eine Vielzahl von beschichteten Substraten in Kassetten gestapelt, die in den Prozessraum des Stapelofens hineingefahren werden. Die Aufheizung erfolgt hier langsam über die beheizten Wände der Ofenkammer. Zur homogenen Aufheizung kann die Konvektion im Ofen noch forciert werden.

Nach der Wärmebehandlung des Vorläufers und der Umwandlung in den Chalkopyrit- oder Kesterit-Halbleiterabsorber ist eine Gasatmosphäre im Prozessraum vorhanden, welche die mindestens eine gasförmige Chalkogenverbindung enthält, die während der Wärmebehandlung des beschichteten Substrats in der Gasatmosphäre bereitgestellt wurde. Es kann aber auch mindestens eine weitere gasförmige Chalkogenverbindung in der Gasatmosphäre vorhanden sein, die durch ein im Vorläufer enthaltenes Chalkogen entstanden ist. Enthält der Vorläufer beispielsweise elementares Selen und wird während der Wärmebehandlung Schwefelwasserstoff bereitgestellt, so kann das Abgas durch chemische Umwandlungen auch Selenwasserstoff enthalten. Das Gasgemisch kann auch Stickstoff oder ein anderes Gas als Träger- oder Spülgas enthalten sowie geringe Spuren von Sauerstoff oder Wasserdampf.

Erfindungsgemäß wird die Gasatmosphäre nach dem Wärmebehandeln des mindestens einen mit einem Vorläufer beschichteten Substrats aus dem Prozessraum entfernt, bevor der Prozessraum mit mindestens einem weiteren mit einem Vorläufer beschichteten Substrat beladen wird. Für die Wärmebehandlung mindestens eines weiteren (noch nicht wärmebehandelten) beschichteten Substrats wird eine neue Gasatmosphäre bereitgestellt, wobei hierzu ein Prozessgas typischer Weise vor und während der Wärmebehandlung des mindestens einen beschichteten Substrats in den Prozessraum eingeleitet wird. Vorzugsweise werden mindestens 90% der Gastatmosphäre, vorteilhaft mindestens 99% der Gasatmosphäre aus dem Prozessraum entfernt, bevor mindestens ein weiteres beschichtetes Substrat in den Prozessraum eingebracht wird.

Die Entfernung der Gasatmosphäre kann durch Spülen und Verdünnen mit einem Inertgas wie Stickstoff oder durch Abpumpen und Fluten mit einem Inertgas erfolgen.

Im Sinne vorliegender Erfindung bezeichnet der Begriff "Abgas" die nach dem Wärmebehandeln mindestens eines beschichteten Substrats aus dem Prozessraum entfernte Gasatmosphäre.

Erfindungsgemäß ist wesentlich, dass das Abgas gereinigt wird, wobei mindestens eine nach der Wärmebehandlung im Abgas enthaltene gasförmige Chalkogenverbindung durch Kühlen des Abgases vom Abgas separiert wird. Im Abgas ist die mindestens eine gasförmige Chalkogenverbindung enthalten, die bei der Wärmebehandlung des mindestens einen beschichteten Substrats im Prozessraum bereitgestellt wurde. Das Abgas kann aber auch eine oder mehrere weitere gasförmige Chalkogenverbindungen enthalten, die während der Wärmebehandlung entstanden sind.

Das Abgas wird zu diesem Zweck so gekühlt, dass mindestens eine gasförmige Chalkogenverbindung im Abgas, insbesondere alle im Abgas enthaltenen gasförmigen Chalkogenverbindungen, wahlweise in eine flüssige oder feste Form (d.h. Aggregatszustand) überführt wird. Vorteilhaft wird der größte Teil einer jeweiligen im Abgas enthaltenen Chalkogenverbindung durch Überführen in eine flüssige oder feste Form aus dem Abgas entfernt, wobei vorzugsweise mindestens 90%, besonders bevorzugt mindestens 99%, noch stärker bevorzugt mindestens 99,99%, der Chalkogenverbindung aus dem Abgas entfernt werden. Vorzugsweise ist eine jeweilige Chalkogenverbindung nach dem Kühlen des Abgases nur noch in einer Konzentration von weniger als 50 ppm in gasförmiger Form im Abgas enthalten, so dass das gereinigte Abgas auch an die äußere Umgebung abgegeben werden kann.

Somit kann das Abgas durch Kühlen in besonders einfacher, kostengünstiger und ökologischer Weise gereinigt werden, wobei mindestens eine gasförmige Chalkogenverbindung wahlweise durch Verfestigen oder Verflüssigen vom Abgas separiert wird. Zudem ist eine Weiterverwendung der separierten (recycelten) Chalkogenverbindung(en) möglich.

Erfindungsgemäß wird das Abgas bis unterhalb des Siedepunkts oder Schmelzpunkts mindestens einer Chalkogenverbindung im Abgas gekühlt, wodurch die im Abgas in gasförmiger Form enthaltene Chalkogenverbindung verflüssigt bzw. verfestigt wird. Durch Überführen der gasförmigen Chalkogenverbindung des Abgases in den flüssigen oder festen Aggregatszustand kann diese vom Abgas separiert werden. Im Sinne vorliegender Erfindung bezeichnet der Begriff "separierte Chalkogenverbindung" die durch Verflüssigung oder Verfestigung vom Abgas getrennte Chalkogenverbindung. Erfindungsgemäß wird mindestens eine gasförmige Chalkogenverbindung vom Abgas separiert. Vorteilhaft werden alle im Abgas enthaltenen gasförmigen Chalkogenverbindungen vom Abgas separiert.

Das Kühlen des Abgases erfolgt in mindestens einem Gasprozessor, der zu diesem Zweck mit einer Gaskühleinrichtung ausgestattet ist. Der Gasprozessor kann zusätzlich oder alternativ über eine Gasheizeinrichtung verfügen, durch die eine verflüssigte oder verfestigte separierte Chalkogenverbindung (nach dem räumlichen Trennen vom Abgas, um eine Vermischung mit dem Abgas zu vermeiden) wieder verdampft werden kann.

Gemäß einer Ausführungsform des erfindungsgemäßen Verfahrens wird mindestens eine separierte Chalkogenverbindung während des fortgesetzten Kühlens des Abgases aus dem Gasprozessor abgeführt, d.h. vom Abgas räumlich getrennt. Diese Ausführungsform kann in einfacher Weise bei einer Verflüssigung mindestens einer Chalkogenverbindung realisiert werden, da sich eine Flüssigkeit beispielsweise durch Abpumpen leicht vom Abgas entfernen lässt. Inbesondere wird mindestens eine verflüssigte Chalkogenverbindung während des fortgesetzten Kühlens des Abgases kontinuierlich abgeführt. Möglich ist jedoch auch ein nicht-kontinuierliches Entfernen mindestens einer verflüssigten Chalkogenverbindung. Das räumliche Trennen mindestens einer separierten Chalkogenverbindung vom Abgas und das Kühlen des Abgases erfolgen also zeitgleich. Mindestens eine abgeführte separierte Chalkogenverbindung kann beispielsweise einem weiteren Gasprozessor zugeführt werden, der mit einer Gasheizeinrichtung versehen ist und kann darin verdampft werden. Das Abgas kann durch fortgesetztes Kühlen solange gereinigt werden, bis der Gehalt an einer jeweiligen Chalkogenverbindung eine gewünschte Maximalgrenze unterschreitet. Zeitgleich kann mindestens eine separierte Chalkogenverbindung aus dem Gasprozessor abgeführt werden.

Gemäß einer alternativen Ausführungsform des erfindungsgemäßen Verfahrens werden mindestens eine separierte Chalkogenverbindung und das Abgas erst nach dem Kühlen des Abgases räumlich voneinander getrennt. Das Kühlen des Abgases und das räumliche Trennen mindestens einer separierten Chalkogenverbindung und des Abgases erfolgen also nicht zeitgleich sondern nacheinander. Möglich ist, dass das Abgas von mindestens einer separierten Chalkogenverbindung abgezogen wird, d.h. das Abgas wird aus dem zum Kühlen eingesetzten Gasprozessor abgezogen, wobei mindestens eine separierte Chalkogenverbindung im Gasprozessor verbleibt. Beispielsweise wird mindesens eine im Gasprozessor verbliebene separierte Chalkogenverbindung im Gasprozessor verdampft, zu welchem Zweck der Gasprozessor mit einer Gasheizeinrichtung versehen ist. Möglich ist aber auch, dass mindestens eine separierte Chalkogenverbindung aus dem Gasprozessor abgeführt wird und Abgas im Gasprozessor verbleibt. Mindestens eine abgeführte separierte Chalkogenverbindung kann beispielsweise einem weiteren Gasprozessor zugeführt werden, der mit einer Gasheizeinrichtung versehen ist und darin verdampft werden. Diese Ausführungsform ist insbesondere bei einer Verfestigung mindestens einer Chalkogenverbindung vorteilhaft, da das Abführen eines Feststoffs aus dem Gasprozessor schwieriger ist als bei einer Flüssigkeit.

Nach dem räumlichen Trennen von Abgas und mindestens einer separierten Chalkogenverbindung kann das Abgas einem weiteren Kühlen unterzogen werden. Dies kann so oft wiederholt werden, bis der Gehalt an einer jeweiligen Chalkogenverbindung eine gewünschte Maximalgrenze unterschreitet.

Wird mindestens eine Chalkogenverbindung im Gasprozessor verflüssigt, ist der Dampfdruck über der Flüssigkeit noch relativ hoch, so dass die Ausbeute geringer ist als bei einer Verfestigung, bei welcher der Dampfdruck über dem Feststoff nur noch sehr gering ist. Ein Überführen in den festen Aggregatszustand kann in dieser Hinsicht vorteilhaft sein, jedoch ist die Rückgewinnung im kontinuierlichen Betrieb schwieriger.

Gemäß einer bevorzugten Ausführungsform des erfindungsgemäßen Verfahrens wird mindestens eine separierte Chalkogenverbindung nach einem räumlichen Trennen vom (verbliebenen) Abgas wieder verdampft, d.h. in den gasförmigen Aggregatszustand gebracht. Dies kann vorteilhaft zu Lagerungszwecken sein. Ein besonderer Vorteil ist jedoch die Möglichkeit, mindestens eine verdampfte separierte Chalkogenverbindung dem Prozessraum für die Wärmebehandlung eines weiteren Substrats wieder zuzuführen. Gemäß einer besonders vorteilhaften Ausführungsform des erfindungsgemäßen Verfahrens wird mindestens eine separierte Chalkogenverbindung in Gasform dem Prozessraum vor und/oder während der Wärmebehandlung eines beschichteten Substrats zugeführt.

Gemäß einer Ausführungsform des erfindungsgemäßen Verfahrens wird mindestens eine separierte Chalkogenverbindung mindestens einem Pufferspeicher zugeführt. Die Lagerung im Pufferspeicher ermöglicht eine einfache anschließende Entsorgung oder Weiterverwendung der (recycelten) Chalkogenverbindung. Die mindestens eine separierte Chalkogenverbindung kann in gasförmigem, flüssigem oder festem Aggregatszustand im Pufferspeicher gelagert werden. Die Temperatur und/oder der Druck im Pufferspeicher können dementsprechend eingestellt werden. Vorteilhaft wird mindestens eine separierte Chalkogenverbindung in Gasform im Pufferspeicher gelagert, insbesondere um dann dem Prozessraum für die Wärmebehandlung mindestens eines beschichteten Substrats zugeführt zu werden.

Das erfindungsgemäße Verfahren kann insbesondere in mindestens zwei zeitlichen Phasen ablaufen: in einer ersten Phase wird mindestens eine Chalkogenverbindung durch Kühlen im Gasprozessor verflüssigt oder ausgefroren und in der zweiten Phase wird die mindestens eine separierte Flüssigkeit oder der mindestens eine Feststoff im selben Gasprozessor oder in einem weiteren Gasprozessor wieder verdampft und dem Pufferspeicher zugeführt. Falls nur ein Gasprozessor eingesetzt wird, kann während des Verdampfens kein weiteres Abgas eingeleitet werden, so dass das Abgas entweder im Prozessraum verbleibt oder in einem weiteren Pufferspeicher zwischengespeichert werden kann. Bei der Verwendung eines zweiten Gasprozessors kann das Abgas in einem Gasprozessor gereinigt werden, während in dem anderen Gasprozessor mindestens eine separierte Chalkogenverbindung zur weiteren Verwendung durch Aufheizen bereitgestellt wird.

Liegen zwei oder mehr gasförmige Chalkogenverbindungen im Abgas vor, so kann das Abgas bis unterhalb des niedrigsten Siedepunkts oder niedrigsten Schmelzpunkts der Chalkogenverbindungen abgekühlt werden, um schrittweise alle Chalkogenverbindungen zu verflüssigen bzw. zu verfestigen. Die verschiedenen gasförmigen Chalkogenverbindungen werden hierzu zeitlich und/oder räumlich voneinander getrennt jeweils in eine flüssige oder feste Form überführt. Auf diese Weise können gezielt einzelne oder alle Chalkogenverbindungen vom Abgas separiert werden (kryogene Separation). Dementsprechend werden gemäß einer Ausgestaltung des erfindungsgemäßen Verfahrens voneinander verschiedene Chalkogenverbindungen zeitlich und/oder räumlich voneinander getrennt vom Abgas separiert. Dies kann in einfacher Weise durch räumlich und/oder zeitlich getrenntes Kühlen des Abgases unterhalb der verschiedenen Siedepunkte oder Schmelzpunkte der im Abgas enthaltenen Chalkogenverbindungen erreicht werden. Wird das Abgas so gekühlt, dass dessen Temperatur zwischen zwei verschiedenen Siedepunkten von zwei Chalkogenverbindungen liegt, kann die verflüssigte Chalkogenverbindung mit dem höheren Siedepunkt vom Abgas separiert werden (und vom Gasprozessor abgeführt werden). Bei einem weiteren Kühlen des Abgases auf eine Temperatur unterhalb des niedrigeren Siedepunkts kann die verflüssigte Chalkogenverbindung mit dem niedrigeren Siedepunkt vom Abgas separtiert werden (und vom Gasprozessor abgeführt werden). Für die Schmelzpunkte der Chalkogenverbindungen gilt dies analog. Durch diese Maßnahme ist in vorteilhafter Weise eine selektive Entsorgung oder Weiterverwendung separierter Chalkogenverbindungen ermöglicht, d.h. Chalkogenverbindungen können getrennt gewonnen und recycelt werden.

Gemäß einer Ausgestaltung des erfindungsgemäßen Verfahrens wird dampfförmiges Wasser zeitlich und/oder räumlich getrennt von mindestens einer im Abgas enthaltenen gasförmigen Chalkogenverbindung vom Abgas separiert. Vorzugsweise wird das verflüssigte oder verfestigte Wasser aus dem Gasprozessor abgeführt bevor durch weiteres Kühlen des Abgases eine gasförmige Chalkogenverbindung verfestigt oder verflüssigt wird. Aufgrund des wesentlich höheren Siede- und Schmelzpunkts des Wassers im Vergleich zu Chalkogenverbindungen wird beim Kühlen des Abgases in aller Regel zunächst das dampfförmige Wasser vom Abgas separiert. Wird das flüssige oder feste Wasser aus dem Gasprozessor entfernt bevor eine Chalkogenverbindung vom Abgas separiert wird, ist die separierte Chalkogenverbindung in vorteilhafter Weise zumindest weitestgehend wasserfrei. Es können somit besonders reine Chalkogenverbindungen rückgewonnen werden.

Mindestens eine separierte Chalkogenverbindung kann in Gasform dem Prozessraum wieder zugeführt werden. Dies ermöglicht in erheblichem Umfang die Einsparung von Kosten, da der Materialeinsatz für die in der Gasatmosphäre eingesetzte mindestens einen Chalkogenverbindung vermindert ist. Zudem ist diese Maßnahme in ökologischer Hinsicht sehr sinnvoll, da die Menge an Sondermüll reduziert wird. Die mindestens eine aus dem Abgas separierte Chalkogenverbindung kann mit einem Verdünnungsgas versetzt werden, beispielsweise Stickstoff, um den Gehalt an der Chalkogenverbindung gezielt einzustellen. Möglich ist auch, dass mehrere Chalkogenverbindungen, die aus dem Abgas separiert wurden, dem Prozessraum wieder zugeführt werden. Dies erleichtert die Verfahrensführung, da die verschiedenen Chalkogenverbindungen nicht einzeln rückgewonnen werden müssen.

Gemäß einer Ausgestaltung des erfindungsgemäßen Verfahrens wird das Abgas im Gasprozessor durch Kontakt mit mindestens einer gekühlten Kontaktfläche gekühlt (Kontaktkühlung). Vorteilhaft wird die mindestens eine Kontaktfläche durch ein (zirkulierendes) flüssiges oder festes Kühlmedium gekühlt, vorzugsweise flüssiger Stickstoff.

Die Erfindung betrifft weiterhin eine Vorrichtung zum Herstellen eines chalkogenhaltigen Verbindungshalbleiters, welche zur Durchführung des erfindungsgemäßen Verfahrens geeignet ausgebildet ist.

Die Vorrichtung umfasst einen Prozessraum zum Bereitstellen mindestens eines beschichteten Substrats, das mit einem Vorläufer für einen chalkogenhaltigen Verbindungshalbleiter beschichtet ist. Der Prozessraum kann ein Kammerhohlraum der Prozesskammer sein. Möglich ist auch, dass der Prozessraum durch eine transportierbare Prozessbox oder eine in der Prozesskammer stationär angeordnete Prozesshaube gebildet wird. Möglich ist auch, dass der Prozessraum ein Stapelofen ist, der eine oder mehrere Kassetten mit jeweils mehreren beschichteten Substraten enthält, die gemeinsam wärmebehandelt werden sollen.

Die Vorrichtung umfasst weiterhin mindestens eine Energiequelle zur Wärmebehandlung des mindestens einen beschichteten Substrats im Prozessraum, welche beispielsweise in Form eines oder mehrerer Heizstrahler zur Erzeugung einer Heizstrahlung ausgebildet ist.

Die Vorrichtung umfasst weiterhin mindestens eine Gaszuleitung zum Zuleiten eines mindestens eine Chalkogenverbindung enthaltenden Prozessgases in den Prozessraum.

Die Vorrichtung umfasst weiterhin mindestens eine Gasableitung zum Entfernen einer Gasatmosphäre nach der Wärmebehandlung des mindestens einen beschichteten Substrats aus dem Prozessraum, welche das zu reinigende Abgas darstellt.

Die Vorrichtung umfasst weiterhin mindestens einen Gasprozessor. Der mindestens eine Gasprozessor ist mit einer Gaskühleinrichtung zum Kühlen des Abgases und Überführen mindestens einer im Abgas enthaltenen Chalkogenverbindung in eine flüssige oder feste Form und/oder mit einer Gasheizeinrichtung zum Verdampfen der verflüssigten oder verfestigten, aus dem Abgas separierten mindestens einen Chalkogenverbindung versehen. Jedenfalls weist die Vorrichtung mindestens einen Gasprozessor mit einer Gaskühleinrichtung auf. Optional kann ein Gasprozessor, neben einer Gaskühleinrichtung, auch eine Gasheizeinrichtung aufweisen. Ein Gasprozessor kann auch nur eine Gasheizeinrichtung (und keine Gaskühleinrichtung) aufweisen. Vorteilhaft sind mindestens zwei Gasprozessoren vorgesehen, wobei mindestens ein Gasprozessor zum Kühlen des Abgases und mindestens ein Gasprozessor zum Verdampfen der verflüssigten oder verfestigten, vom Abgas separierten mindestens einen Chalkogenverbindung ausgebildet ist. Jeder der mindestens zwei Gasprozessoren kann zum Kühlen des Abgases und Verdampfen der verflüssigten oder verfestigten, vom Abgas separierten mindestens einen Chalkogenverbindung ausgebildet sein.

Vorzugsweise werden mindestens zwei Gasprozessoren zeitlich zyklisch betrieben: während in dem einen Gasprozessor das Gasgemisch aus dem Prozessraum durch Verflüssigung oder Einfrierung separiert wird, werden in dem anderen Gasprozessor die separierten Flüssigkeiten oder Feststoffe wieder aufgeheizt und dem Pufferspeicher zugeführt.

Besonders bevorzugt weist die Kühleinrichtung mindestens eine kühlbare Kontaktfläche für das Abgas auf, die vorteilhaft durch ein innerhalb eines Kühlkreises zirkulierendes flüssiges Kühlmedium, insbesondere flüssigen Stickstoff, kühlbar ist. Die Gasprozessoren können eingebaute Wärmequellen (elektrische Heizelemente oder zugeführte fluide flüssige Wärmeträger) aufweisen, um die flüssigen oder festen Chalkogenverbindungen wieder in den gasförmigen Zustand zu überführen.

Gemäß einer Ausgestaltung der erfindungsgemäßen Vorrichtung weist diese mindestens einen mit dem Gasprozessor fluidleitend (strömungstechnisch) gekoppelten Pufferspeicher zum Speichern mindestens einer aus dem Abgas entfernten Chalkogenverbindung auf.

Gemäß einer Ausgestaltung der erfindungsgemäßen Vorrichtung sind der mindestens eine Gasprozessor und/oder der mindestens eine Pufferspeicher fluidleitend (strömungstechnisch) mit einer Gaszuleitung in den Prozessraum gekoppelt. Möglich ist, dass der Prozessraum eine erste Gaszuleitung aufweist, die dazu dient, dass ein primäres Prozessgas, welches mindestens eine nicht vom Abgas separierte Chalkogenverbindung enthält, über die erste Gaszuleitung in den Prozessraum eingeleitet wird, und dass der Prozessraum eine zweite Gaszuleitung aufweist, die dazu dient, dass ein zweites Prozessgas, das mindestens eine vom Abgas separierte Chalkogenverbindung enthält (oder aus dieser besteht), in den Prozessraum eingeleitet wird. Die erste Gaszuleitung und die zweite Gaszuleitung können auch zu einer gemeinsamen Gaszuleitung zusammengefasst sein. Inbesondere können das primäre Prozessgas und das sekundäre Prozessgas vor bzw. beim Einleiten in den Prozessraum gemischt werden.

Für die Ausgestaltung der Vorrichtung zum Herstellen eines chalkogenhaltigen Verbindungshalbleiterss zur Durchführung des erfindungsgemäßen Verfahrens wird ergänzend auf obige Ausführungen zum erfindungsgemäßen Verfahren Bezug genommen.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

### Kurze Beschreibung der Zeichnungen

Die Erfindung wird nun näher erläutert, wobei Bezug auf die beigefügten Figuren genommen wird. Es zeigen:
- Fig. 1: eine schematische Darstellung einer Ausführungsform der Vorrichtung zum Herstellen eines chalkogenhaltigen Verbindungshalbleiters;
- Fig. 2: ein Flussdiagramm zur Veranschaulichung der Verfahrensschritte des erfindungsgemäßen Verfahrens zum Herstellen eines chalkogenhaltigen Verbindungshalbleiters.

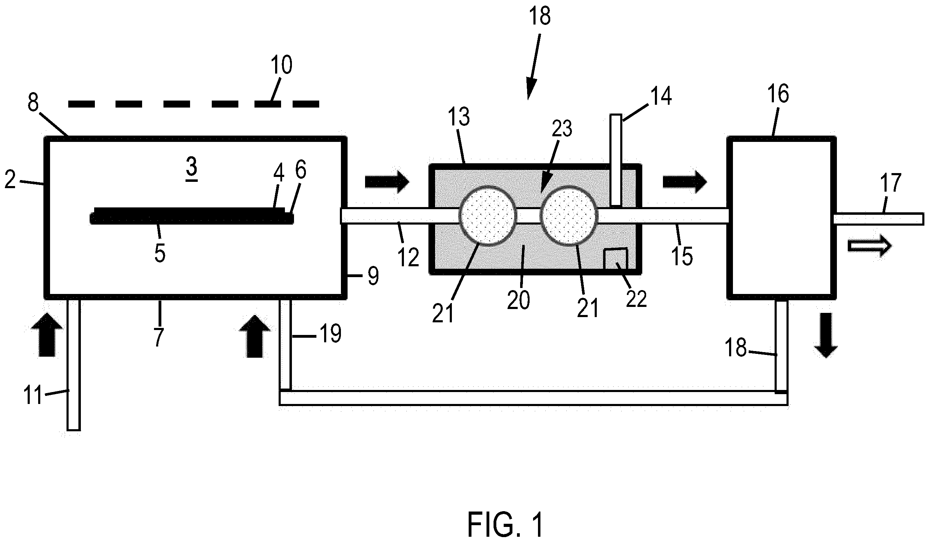

Sei zunächst Figur 1 betrachtet, worin anhand einer schematischen Darstellung eine insgesamt mit der Bezugszahl 1 bezeichnete Vorrichtung zum Herstellen eines chalkogenhaltigen Verbindungshalbleiters veranschaulicht ist.

Die Vorrichtung 1 umfasst eine Prozessraumwandung 2, die beispielsweise durch eine Prozessbox oder einen Ofenraum gebildet wird, und einen Prozessraum 3 umgrenzt, der für die Aufnahme mindestens eines Subtrats 5 dient, das mit einem Vorläufer 4 beschichtet ist. Der Vorläufer 4 ist auf einer Oberfläche 6 des Subtrats 5 aufgebracht und dient zur Herstellung eines chalkogenhaltigen Verbindungshalbleiters. Die Prozesswandung 2 umfasst eine Bodenwand 7, eine Deckenwand 8, sowie eine Seitenwand 9, die Bodenwand 7 und Deckenwand 8 miteinander verbindet und gleichzeitig als Abstandhalter für Bodenwand 7 und Deckenwand 8 dient. Bodenwand 7, Deckenwand 8 und Seitenwand 9 formen gemeinsam den Prozessraum 3, in dem das mit einem Vorläufer 4 beschichtete Substrat 5 einer Wärmebehandlung unterzogen werden kann. Das Substrat 5 liegt beispielsweise der Bodenwand 7 innenseitig auf. Falls die Prozessraumwandung 2 durch eine Prozessbox gebildet wird, können Bodenwand 7, Deckenwand 8 und Seitenwand 9 lösbar miteinander verbunden sein. Falls die Prozessraumwandung 2 durch einen Stapelofen gebildet wird, können Bodenwand 7, Deckenwand 8 und Seitenwand 9 fest miteinander verbunden sein. Insbesondere kann die Prozessraumwandung 2 auch durch einen Rohrofen gebildet sein.

Das mindestens eine Substrat 5 ist z.B. eine Glasplatte. Auf die Oberfläche 6 des Substrats 5 ist eine Rückelektrodenschicht (nicht näher dargestellt) aufgebracht. Auf der Rückelektrodenschicht befindet sich der Vorläufer 4, der zu einem chalkogenhaltigen Verbindungshalbleiter thermisch umgesetzt werden soll. Beispielsweise für die Herstellung einer Cu(In,Ga)(S,Se)₂-Absorberschicht besteht der Vorläufer 4 aus verschiedenen Einzellagen, welche Kupfer, Indium und Gallium enthalten, die beispielsweise durch Sputtern aufgebracht sind. Weiterhin kann der Vorläufer 4 auch ein Chalkogen in elementarer Form aufweisen, vorzugsweise Selen und/oder Schwefel, welches vorzugsweise durch thermisches Verdampfen aufgebracht wird. Der Vorläufer 4 wird durch Erwärmen in einer mindestens eine Chalkogenverbindung enthaltenden Gasatmoshäre im Prozessraum 3, vorzugsweise eine Selen- und/oder Schwefelverbindung, zum Cu(In,Ga)(S,Se)₂-Verbindungshalbleiter reagiert. Beispielsweise enthält der Vorläufer 4 als Chalkogen nur elementares Selen und die thermische Umsetzung des Vorläufers erfolgt in einer Gasatmosphäre, die als Chalkogen nur Schwefel in einer Schwefelverbindung enthält (z.B. Schwefelwasserstoff). Die thermische Umsetzung des Vorläufers 4 erfolgt im Prozessraum 3.

Angrenzend an und unmittelbar benachbart zur Deckenwand 8 befindet sich als Energiequelle ein Strahlerfeld 10 mit einer Vielzahl von in einer ein- oder zweidimensionalen Anordnung (Array) platzierten Heizstrahlern (z.B. Halogenlampen, Infrarotstrahler oder Flächenstrahler) zum Emittieren von Heizstrahlung zum oberseitigen Heizen des Vorläufers 4. In analoger Weise befindet sich angrenzend an und unmittelbar benachbart zur Bodenwand 7 als unterseitige Energiequelle ein weiteres Strahlerfeld, welches der Einfachheit halber in Figur 1 nicht dargestellt ist. In einem Stapelofen ist vorzugsweise auch die Seitenwand 9 durch Energiequellen beheizt. Die Heizstrahler des Strahlerfelds 10 emittieren eine Heizstrahlung, welche die (hier beispielsweise teiltransparente) Deckenwand 8 teilweise passiert und auf den Vorläufer 4 trifft. Ein Teil der Heizstrahlung wird von der Deckenwand 8 absorbiert, wodurch die Deckenwand 8 erwärmt wird, die dann ihrerseits Wärmestrahlung 9 emittiert, die gleichermaßen den Vorläufer 4 heizt. Eine bodenseitige Heizung des Vorläufers 4 durch das (nicht gezeigte) unterseitige Strahlerfeld erfolgt in analoger Weise. In einem Stapelofen mit mehreren Substraten muss die Wärmeenergie auch durch Konvektion den innenliegenden Substraten zugeführt werden.

Nach dem Ablegen des mit dem Vorläufer 4 beschichteten Subtrats 5 im Prozessraum 3 oder nach dem Einführen von Kassetten mit mehreren beschichteten Substraten wird der Prozessraum 3 geschlossen und über eine in den Prozessraum 3 mündende erste Gaszuleitung 11 mit einem mindestens eine Chalkogenverbindung enthaltendem (primären) Prozessgas befüllt. Danach erfolgt das Temperieren des beschichteten Substrats 5 mit einer Temperierrate von mehreren °C pro Sekunde, beispielsweise 5 °C/s. In einem Stapelofen werden die mehreren Substrate eher langsam erwärmt, um durch Konvektion und Strahlung eine gleichmäßige Erwärmung herbeizuführen und Glasbruch und Glasverbiegung zu vermeiden. Während des Temperierens des beschichteten Substrats 5 kann, falls erforderlich, weiterhin das primäre Prozessgas in den Prozessraum 3 eingeleitet werden. Beispielsweise ist im Vorläufer 4 nur Selen (Se) als Chalkogen enthalten und als primäres Prozessgas wird durch gasförmigen Stickstoff (N₂) verdünnter Schwefelwasserstoff (H₂S) in den Prozessraum 3 eingeleitet. Alternativ ist im Vorläufer kein Chalcogen enthalten und als primäre Prozessgase werden H₂Se und H₂S zugeführt. Das Zuführen des primären Prozessgases in den Prozessraum 3 ist in Figur 1 durch einen Pfeil neben der ersten Gaszuleitung 11 veranschaulicht.

Nach Abschluss der Wärmebehandlung des Vorläufers 4 und Umsetzung des Vorläufers 4 zum chalkogenhaltigen Verbindungshalbeiter wird die Gasatmosphäre im Prozessraum 3 durch eine in den Prozessraum 3 mündende Gasausleitung 12 aus dem Prozessraum 3 abgezogen. Das Abziehen der Gasatmosphäre aus dem Prozessraum 3 ist in Figur 1 durch einen Pfeil über der Gasausleitung 12 veranschaulicht. Die abgezogene Gasatmosphäre ist das zu reinigende Abgas.

Die Gasausleitung 12 ist zu diesem Zweck fluidleitend an einen Gasprozessor 13 angeschlossen. Mittels der Gasausleitung 12 wird das Abgas in den Gasprozessor 13 geleitet. Der Gasprozessor 13 dient zum aktiven Kühlen des Abgases, wobei hierdurch mindestens die im primären Prozessgas zugeführte Chalkogenverbindung (hier z.B. Schwefelwasserstoff und/oder Selenwasserstoff) zu mindestens 99% aus dem Abgas entfernt wird. Das Abgas wird zu diesem Zweck bis unterhalb des Siedepunkts der jeweiligen Chalkogenverbindung gekühlt, so dass die Chalkogenverbindung verflüssigt wird und vom Abgas getrennt werden kann. Das Abgas kann auch bis unter den Schmelzpunkt der Chalcogenverbindung gekühlt werden, so dass es als Feststoff temporär abgeschieden wird. Das auf diese Weise gereinigte Abgas kann nun über einen Gasauslass 14 an die äußere Umgebung abgegeben werden.

Die vom Abgas separierte (recycelte) Chalkogenverbindung wird durch eine Verbindungsleitung 15 von dem Gasprozessor 13 in einen Pufferspeicher 16 überführt. Das Überführen der recycelten Chalkogenverbindung in Gasform in den Pufferspeicher 16 ist in Figur 1 durch einen Pfeil über der Verbindungsleitung 15 veranschaulicht.

Falls mindestens eine Chalkogenverbindung verflüssigt oder verfestigt wird, kann sie während oder nach dem Kühlen des Abgases vom Gasprozessor 13 entfernt werden. Insbesondere bei einer Verflüssigung ist ein Entfernen aus dem Gasprozessor 13 auch während der Kühlen des Abgases, insbesondre kontinuierlich, möglicht. Insbesondere im Falle der Kondensation mindestens einer Chalkogenverbindung als Feststoff kann der Gasprozessor 13 zyklisch in zwei Phasen betrieben werden. In einer ersten Phase wird mindestens eine Chalkogenverbindung durch Verfestigen vom Abgas separiert. In einer zweiten Phase wird der Feststoff verdampft und kann im Pufferspeicher 16 gesammelt werden. In Figur 1 nicht gezeigt, aber bevorzugt, ist die Verwendung von mindestens zwei Gasprozessoren 13, wobei ein Gasprozessor 13 zum Kühlen des Abgases und Separieren mindestens einer Chalkogenverbindung dient, wobei im anderen Gasprozesser 13 die separierte mindestens eine Chalkogenverbindung verdampft wird.

Im Pufferspeicher 16 kann die recycelte Chalkogenverbindung in gasförmiger, flüssiger oder fester Form gespeichert werden, abhängig von Druck und Temperatur im Pufferspeicher 16. Insbesondere im flüssigen und festen Zustand kann die recycelte Chalkogenverbindung in einfacher Weise einer weiteren Verwendung oder Entsorgung zugeführt werden, was durch einen ersten Pufferspeicherauslass 17 und den darunter befindlichen Pfeil veranschaulicht ist. Bei einer Speicherung in Gasform kann die recycelte Chalkogenverbindung dem Prozessraum 3 zugeführt werden.

Der Pufferspeicher 16 verfügt weiterhin über einen zweiten Pufferspeicherauslass 18, der an eine in den Prozessraum 3 mündende zweite Gaszuleitung 19 fluidleitend (strömungstechnisch) angeschlossen ist. Über die zweite Gaszuleitung 19 kann die recycelte Chalkogenverbindung (z.B. Schwefelwasserstoff) in Gasform als sekundäres Prozessgas in den Prozessraum 3 eingeleitet werden. Dies ist durch einen Pfeil neben dem zweiten Pufferspeicherauslass 17 veranschaulicht. Insbesondere kann der Gehalt an Chalkogenverbindung im primären Prozessgas hierdurch vermindert werden, so dass die bei der Wärmebehandlung mindestens eines weiteren beschichteten Substrats 5 im primären Prozessgas zugeführte Menge an Chalkogenverbindung (z.B. Schwefelwasserstoff) vermindert werden kann. Dies spart in erheblichem Umfang Material und Kosten ein. Das Zuführen der recycelten Chalkogenverbindung als sekundäres Prozessgas in den Prozessraum 3 ist durch einen Pfeil neben der zweiten Gaszuleitung 19 veranschaulicht. Es ist denkbar, dass die recycelte Chalkogenverbindung mit einem Verdünnungsgas, beispielsweise Stickstoff (N2), versetzt wird, um die Menge an Chalkogenverbindung im sekundären Prozessgas gezielt einzustellen. Möglich ist auch, dass das sekundäre Prozessgas und das primäre Prozessgas vor dem Einleiten in den Prozessraum 3 vermischt werden, wobei insbesondere die Konzentration an Chalkogenverbindung(en) durch das Verdünnungsgas des primären Prozessgases eingestellt werden kann. Auf die zweite Gaszuleitung 19 kann dann verzichtet werden. Die Verbindungsleitungen sind zweckmäßigerweise durch Ventile abgesichert. So kann auch der zyklische Betrieb gesteuert werden.

Bei der Wärmebehandlung des Vorläufers 4 kann das Chalkogen im Vorläufer 4 (zu einem geringen Teil) in die Gasatmosphäre übergehen, so dass das Abgas auch eine Chalkogenverbindung durch Chalkogen aus dem Vorläufer 4 enthalten kann.

Auch diese Chalkogenverbindung kann im Gasprozessor 13 vom Abgas separiert werden, entweder gemeinsam mit der mindestens einen Chalkogenverbindung des ersten Prozessgases oder allein. Möglich ist, dass eine Mischung aller vom Abgas separierten Chalkogenverbindungen im Pufferspeicher 16 gelagert und/oder dem Prozessraum 3 zugeführt wird, wodurch die Verfahrensführung erleichtert sein kann. Gleichermaßen ist eine Separierung von dampfförmigen Wasser aus dem Abgas möglich.

Der schematisch dargestellte Gasprozessor 13 umfasst eine Kühleinrichtung 23 mit einem Kühlraum 20, in den das Abgas eingeleitet werden kann. Der Kühlraum 20 ist mit gekühlten Kontaktflächen 21 versehen, die zur Kühlung des Abgases dienen. Eine Kühlung der Kontaktflächen 21 erfolgt durch ein Kühlmedium, hier beispielsweise ein innerhalb eines Kühlkreises zirkulierendes flüssiges Kühlmedium, insbesondere flüssiger Stickstoff.

Optional ist der Gasprozessor 13 zur beschleunigten Wartung, aber auch zur Rückgewinnung (Verdampfen) einer verflüssigten oder kondensierten Chalcogenverbindung mit einer Heizeinrichtung 22 versehen.

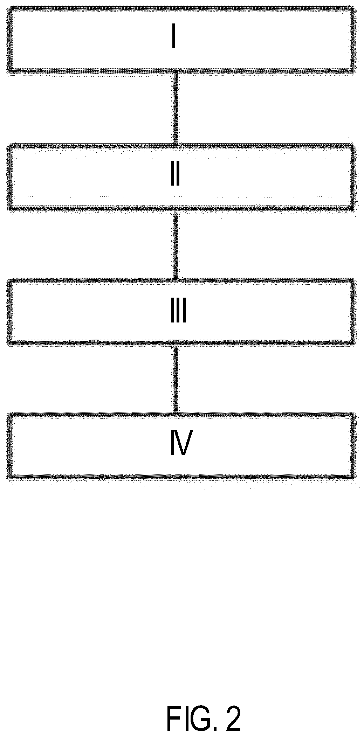

In Figur 2 ist anhand eines Flussdiagramms das Verfahren zur Herstellung eines chalkogenhaltigen Verbindungshalbleiters veranschaulicht.

Demnach wird in einem ersten Schritt I ein mit einem Vorläufer 4 für den chalkogenhaltigen Verbindungshalbleiter beschichtetes Substrat 5 in einem Prozessraum 3 bereitgestellt. In einem zweiten Schritt II wird der Vorläufer 4 im Prozessraum 3 wärmebehandelt, wobei während der Wärmebehandlung eine Gasatmosphäre, die mindestens eine Chalkogenverbindung aufweist, im Prozessraum 3 bereitgestellt wird. In einem dritten Schritt III wird nach Wärmebehandeln des Vorläufers 4 die im Prozessraum 3 vorliegende Gasatmosphäre als Abgas entfernt, und in einem vierten Schritt wird das Abgas gereinigt, wobei mindestens eine im Abgas enthaltene Chalkogenverbindung (die gasförmigen Chalkogenverbindungen, welche bei der Wärmebehandlung des mindestens einen beschichteten Substrats in der Gasatmosphäre bereitgestellt wurden oder während der Wärmebehandlung entstanden sind) durch Kühlen des Abgases und Verflüssigen oder Vefestigen der Chalkogenverbindung mindestens teilweise aus dem Abgas entfernt wird.

Eine kryogene Separation von Chalkogenverbindungen aus dem Abgas kann in einfacher Weise mittels des Gasprozessors 13 erfolgen. In der unten stehenden Tabelle sind die Schmelz- und Siedepunkte beispielhafter Komponenten des Abgases aufgelistet:

| | Schmelzpunkt [°C] | Siedepunkt [°C] |
|---|---|---|
| H₂O | 0 | 100 |
| H₂Se | -66 | -41 |
| H₂S | -86 | -60 |
| N₂ | -210 | -195,8 |
| O₂ | -218,8 | -183 |

Somit kann durch zunehmendes Kühlen des Abgases auf Temperaturen unterhalb von 0°C zunächst Restwasser (H₂O) abgefangen werden. Anschließend können bei Temperaturen um den Siedepunkt von Selenwasserstoff (-41°C) und Schwefelwasserstoff (-60°) diese (giftigen) Gase vom Abgas separiert werden, wobei insbesondere auch eine getrennte Separierung möglich ist, wenn auf Zwischentemperaturen gekühlt wird. Durch Kühlen des Abgases auf Temperaturen unterhalb der Schmelzpunkte von Selenwasserstoff (-66°C) und Schwefelwasserstoff (-86°) können diese Vebindungen auch ausgefroren werden, wobei Stickstoff (N₂) und Sauerstoff (O₂) weiterhin gasförmig bleiben. Die Temperatur von flüssigem Stickstoff beträgt maximal -195,8°C, so dass die Kühlflächen der Kühleinrichtung 23 für eine kryogene Separierung der Chalkogenverbindungen gut kühlbar sind.

Wie sich aus obigen Ausführungen ergibt, stellt die Erfindung ein verbessertes Verfahren und eine entsprechende Vorrichtung zur Herstellung eines chalkogenhaltigen Verbindungshalbleiters zur Verfügung, bei dem das bei der Wärmebehandlung des Vorläufers anfallende Abgas durch Kühlen in einfacher und kostengünstiger Weise gereinigt werden kann (kryogene Separation von Chalkogenverbindungen). In besonders vorteilhafter Weise können die recycelte(n) Chalkogenverbindung(en) wieder verwendet werden, insbesondere als (sekundäres) Prozessgas bei der Wärmebehandlung mindestens eines weiteren beschichteten Subtrats. Bei der Herstellung von Dünnschichtsolarzellen können hierdurch in erheblichem Umfang Material und Kosten eingespart werden. Zudem ist das erfindungsgemäße Verfahren durch Recyceln giftiger Chalkogenverbindungen und die hierdurch erreichte Verringerung von Sondermüll in ökologischer Hinsicht sehr vorteilhaft.

### Bezugszeichenliste

- 1: Vorrichtung
- 2: Prozessraumwandung
- 3: Prozessraum
- 4: Vorläufer
- 5: Substrat
- 6: Oberfläche
- 7: Bodenwand
- 8: Deckenwand
- 9: Seitenwand
- 10: Strahlerfeld
- 11: erste Gaszuleitung
- 12: Gasausleitung
- 13: Gasprozessor
- 14: Gasauslass
- 15: Verbindungsleitung
- 16: Pufferspeicher
- 17: erster Pufferspeicherauslass
- 18: zweiter Pufferspeicherauslass
- 19: zweite Gaszuleitung
- 20: Kühlraum
- 21: Kontaktfläche
- 22: Heizeinrichtung
- 23: Kühleinrichtung

## Patentansprüche

1. Verfahren zum Herstellen eines chalkogenhaltigen Verbindungshalbleiters, welches umfasst:
- Bereitstellen mindestens eines mit einem Vorläufer (4) für den chalkogenhaltigen Verbindungshalbleiter beschichteten Substrats (5) in einem Prozessraum (3),
- Wärmebehandeln des mindestens einen beschichteten Substrats (5) im Prozessraum (3), wobei während der Wärmebehandlung eine Gasatmosphäre, die mindestens eine gasförmige Chalkogenverbindung aufweist, im Prozessraum (3) bereitgestellt wird,
- Entfernen der nach dem Wärmebehandeln des beschichteten Substrats (5) vorliegenden Gasatmosphäre als Abgas aus dem Prozessraum (3),
- Kühlen des Abgases in einem Gasprozessor (13), wobei mindestens eine gasförmige Chalkogenverbindung, die nach dem Wärmebehandeln des beschichteten Substrats (5) im Abgas vorhanden ist, durch Überführen in eine flüssige oder feste Form vom Abgas separiert wird.

2. Verfahren nach Anspruch 1, bei welchem mindestens 99% mindestens einer im Abgas vorhandenen Chalkogenverbindung in eine flüssige oder feste Form überführt werden.

3. Verfahren nach einem der Ansprüche 1 oder 2, bei welchem mindestens eine vom Abgas separierte Chalkogenverbindung während des Kühlens des Abgases aus dem Gasprozessor (13) abgeführt wird.

4. Verfahren nach einem der Ansprüche 1 bis 3, bei welchem mindestens eine vom Abgas separierte Chalkogenverbindung oder das Abgas nach dem Kühlen des Abgases aus dem Gasprozessor (13) abgeführt wird.

5. Verfahren nach einem der Ansprüche 1 bis 4, bei welchem mindestens eine vom Abgas separierte Chalkogenverbindung verdampft wird.

6. Verfahren nach einem der Ansprüche 1 bis 5, bei welchem mindestens eine vom Abgas separierte Chalkogenverbindung mindestens einem Pufferspeicher (16) zugeführt wird.

7. Verfahren nach einem der Ansprüche 5 oder 6, bei welchem mindestens eine vom Abgas separierte Chalkogenverbindung dem Prozessraum (3) in Gasform zugeführt wird.

8. Verfahren nach einem der Ansprüche 1 bis 7, bei welchem im Abgas enthaltenes dampfförmiges Wasser zeitlich und/oder räumlich getrennt von mindestens einer im Abgas vorhandenen Chalkogenverbindung durch Überführen in eine flüssige oder feste Form vom Abgas separiert wird.

9. Verfahren nach einem der Ansprüche 1 bis 8, bei welchem mehrere Chalkogenverbindungen durch jeweiliges Überführen in eine flüssige oder feste Form zeitlich und/oder räumlich getrennt voneinander vom Abgas separiert werden.

10. Verfahren nach einem der Ansprüche 1 bis 9, bei welchem eine Mischung mehrerer vom Abgas separierter Chalkogenverbindungen dem Prozessraum (3) in Gasform zugeführt wird.

11. Vorrichtung zum Herstellen eines chalkogenhaltigen Verbindungshalbleiters durch ein Verfahren nach einem der Ansprüche 1 bis 10, welche umfasst:
- einen Prozessraum (3) zum Bereitstellen mindestens eines Substrats (5), das mit einem Vorläufer (4) für den chalkogenhaltigen Verbindungshalbleiter beschichtet ist,
- mindestens eine Energiequelle (10) zur Wärmebehandlung des mindestens einen beschichteten Substrats (5) im Prozessraum (3),
- mindestens eine Gaszuleitung (12) zum Zuleiten eines mindestens eine Chalkogenverbindung enthaltenden Prozessgases in den Prozessraum (3),
- mindestens eine Gasausleitung (12) zum Entfernen einer Gasatmosphäre aus dem Prozessraum (3) als Abgas,
- mindestens einen Gasprozessor (13), in dem das Abgas gekühlt werden kann, so dass mindestens eine gasförmige Chalkogenverbindung, die nach der Wärmebehandlung des mindestens einen beschichteten Substrats (5) im Prozessraum (3) vorhanden ist, durch Überführen in eine flüssige oder feste Form vom Abgas separiert wird.

12. Vorrichtung nach Anspruch 11, welche mindestens eine Heizeinrichtung (22) zum Verdampfen mindestens einer vom Abgas in flüssiger oder festen Form separierten Chalkogenverbindung aufweist.

13. Vorrichtung nach Anspruch 11 oder 12, welche mindestens einen mit dem Gasprozessor (13) fluidleitend gekoppelten Pufferspeicher (16) zum Speichern mindestens einer vom Abgas separierten Chalkogenverbindung aufweist.

14. Vorrichtung nach einem der Ansprüche 11 bis 13, bei welcher der Gasprozessor (13) oder Pufferspeicher (16) fluidleitend mit einer Gaszuleitung (19) in den Prozessraum (3) gekoppelt ist.

15. Vorrichtung nach einem der Ansprüche 11 biss 14, bei welcher der Prozessraum (3) mit mindestens zwei Gasprozessoren (13) verbunden ist, die dazu ausgebildet sind, mindestens eine vom Abgas separierte Chalkogenverbindung in einem Gasprozessor zu verdampfen, während im anderen Gasprozessor mindestens eine Chalkogenverbindung vom Abgas separiert wird.
